# EUROPEAN PATENT SPECIFICATION

(11) **EP 2 554 720 B1**
(45) Date of publication and mention of the grant of the patent: **24.04.2019**
(21) Application number: 11762541.8
(22) Date of filing: 11.03.2011
(51) Int. Cl.: C30B 29/48, C01B 19/04, C22C 1/02, C30B 11/00, C01B 19/00

(54) **METHOD FOR SYNTHESIZING GROUP II-VI COMPOUND SEMICONDUCTOR POLYCRYSTALS**
VERFAHREN ZUR SYNTHETISIERUNG VON GRUPPE II-VI-VERBUNDHALBLEITER-POLYKRISTALLEN
PROCÉDÉ PERMETTANT DE SYNTHÉTISER DES POLYCRISTAUX SEMI-CONDUCTEURS DE COMPOSÉS DES GROUPES II-VI

(30) Priority: 29.03.2010 JP 2010074010
(43) Date of publication of application: 06.02.2013
(73) Proprietor: JX Nippon Mining & Metals Corporation, Tokyo 100-8164 (JP)
(72) Inventor: ASAHI, Toshiaki, Hitachi-shi Ibaraki 317-0056 (JP); NODA, Akira, Kitaibaraki-shi Ibaraki 319-1535 (JP)
(74) Representative: Gill Jennings & Every LLP
(86) International application number: PCT/JP2011/055748
(87) International publication number: WO 2011/122301

(56) References cited:
- JP-A- 4 362 083
- JP-A- 8 259 399
- JP-A- 2003 277 197
- US-A- 5 167 759
- US-A- 5 685 907
- R. LAUCK ET AL.: 'Vapour transport of impurities in semi-closed ampoules : II. Doping profiles, refining and stoichiometry in crystal growth of II-VI compounds' JOURNAL OF CRYSTAL GROWTH vol. 74, no. 3, 1986, pages 520 - 528, XP024439037
- M. ZHA ET AL.: 'Heat treatment in semi-closed ampoule for obtaining stoichiometrically controlled cadmium telluride' JOURNAL OF CRYSTAL GROWTH vol. 237-239, no. 3, 2002, pages 1720 - 1725, XP004356246
- M. LAASCH ET AL.: 'Growth of twin-free CdTe single crystals in a semi-closed vapour phase system' JOURNAL OF CRYSTAL GROWTH vol. 174, no. 1-4, 1997, pages 696 - 707, XP004113798

## Description

### Field of the Invention

The present invention relates to a method for synthesizing group II-VI compound semiconductor polycrystals as raw materials of group II-VI compound semiconductor single crystals, and particularly relates to a method for synthesizing CdTe family compound semiconductor polycrystal, particularly CdTe polycrystal.

### Background Art

A compound semiconductor polycrystal has to be synthesized from a group II element and a group VI element at first for synthesizing a group II-VI compound semiconductor single crystal. Conventionally, a group II-VI compound semiconductor was synthesized by putting a group II single element and a group VI single element in a semi-airtight pBN inner vessel, sealing the inner vessel, setting the inner vessel in an airtight outer vessel of a quartz ampoule, vacuum sealing the outer vessel, and heating the outer vessel in an electric furnace up to a melting point or more so as to melt and react the raw elements.

Patent Document 1 and Patent Document 2, for example, disclose such a kind of synthesizing method of polycrystals.

Patent document 3 discloses a method for the preparation of single crystals of group II-VI compounds such as CdTe. The method includes melting a source material in a pBN container by heating in a furnace body and solidifying the melt by cooling from the bottom to grow a single crystal. The apparatus includes a pBN container for holding the source material, a hermetical furnace body including a heater to heat the container, an airtight chamber inside the heater made of a suitable material such as graphite hermetically coated with pyrolitic graphite which encloses the container and a pressure equalizing passage communicating with the airtight chamber and forming a lower portion of the chamber.

### Prior Art

### Patent Document

Patent Document 1: JP Patent No. 2517803
Patent Document 2: JP 2003-277197A
Patent Document 3: US5685907

### Summary of the Invention

### Problems to be Solved

When synthesizing a group II-VI compound semiconductor polycrystal as a raw material of a group II-VI compound semiconductor single crystal, it is desirable to use a larger vessel so as to synthesize a large amount of polycrystal efficiently at a time for reducing synthesizing costs. However, in a case where an airtight quartz ampoule is used as disclosed in Patent Documents 1 and 2, there is a problem that the larger the size of the quartz ampoule, the more difficult to handle the quartz ampoule and easier to break the quartz ampoule due to increase of pressure during the synthesis, which result in a low yield.

In addition, in the synthesis method using a quartz ampoule, the quartz ampoule was disposed because a synthesized polycrystal has to be taken out by breaking the ampoule after synthesis. Thus it also causes difficulty to reduce the costs.

It is an object of the present invention to provide a method for synthesizing group II-VI compound semiconductor polycrystals without using a quartz ampoule as a synthesis vessel for the polycrystals, which contributes to a size up of a synthesis vessel and reduction of the synthesis costs while the yield is not lowered.

### Means to Solve the Problems

To achieve above object, a method for synthesizing group II-VI compound semiconductor polycrystals according to claim 1 includes steps of:
putting two or more raw material elements in a semi-airtight pBN inner vessel and putting the inner vessel in a semi-airtight heat-resistant outer vessel,
placing the outer vessel in a high-pressure furnace having a heating means,
evacuating the high-pressure furnace and filling the high-pressure furnace with an inert gas at a predetermined pressure,
heating the inner vessel and the outer vessel by the heating means so as to melt and promote a reaction of the raw material elements in the inner vessel, and
cooling the reacted raw material elements so as to promote a growth of a polycrystal.

According to the method above explained, it becomes possible to upsize a vessel for synthesis of polycrystals because it becomes not necessary to use a quartz ampoule, which is difficult to upsize, as a vessel for synthesis. Furthermore, when using a quartz ampoule as a vessel for synthesis of polycrystals, the quartz ampoule may burst during the synthesis process and result in a failure of the synthesis, which causes decreasing of a yield. However, the present invention provides a synthesizing method without using a quartz ampoule and contributes cost reduction by virtue of the reuse of a vessel.

According to the invention, the outer vessel is made of graphite and a surface of which is covered with a coating layer.

It becomes easy to handle the outer vessel because the outer vessel is made of graphite. Also it becomes possible to restrict leakage of gasified raw materials from the outer vessel during heating by coating the surface of the outer vessel even when the vessel is made of graphite.

According to the invention, the inert gas pressure in the high-pressure furnace before heating is 0.5 MPa to 1MPa.

It becomes possible to reduce leakage of gasified raw materials from the vessel during the heating by setting the inert gas pressure in the high-pressure furnace before heating at 0.5 MPa to 1MPa.

In a preferred embodiment of the invention, the group II-VI compound semiconductor polycrystal is a CdTe polycrystal, and a temperature raising rate at the heating step is 100 to 2000 degrees C per hour.

It becomes possible to eliminate remaining of non-reacted materials and accomplish the synthesis of CdTe polycrystals completely by setting the temperature raising rate at the heating at 100 to 2000 degrees C per hour.

### Effect of the Invention

According to the present invention, it becomes possible to synthesize group II-VI compound semiconductor polycrystals without using a quartz ampoule as a synthesis vessel and thus it becomes possible to upsize a vessel for synthesis, which results in reduction of a synthesis cost.

### BRIEF DESCRIPTION OF THE DRAWINGS

FIG. 1 is a schematic structure of a crystal synthesizing device for synthesizing a CdTe polycrystal according to an exemplary embodiment of the present invention,
FIG. 2 is a chart graph showing temperature change of a heating device during a synthesis process of a CdTe polycrystal according to an exemplary embodiment of the present invention, and
FIG. 3 is a schematic structure of a conventional crystal synthesizing device for synthesizing CdTe polycrystals.

### Preferred Embodiment to Carry Out the Invention

An exemplary embodiment of the present invention will be explained below with reference to the drawings.

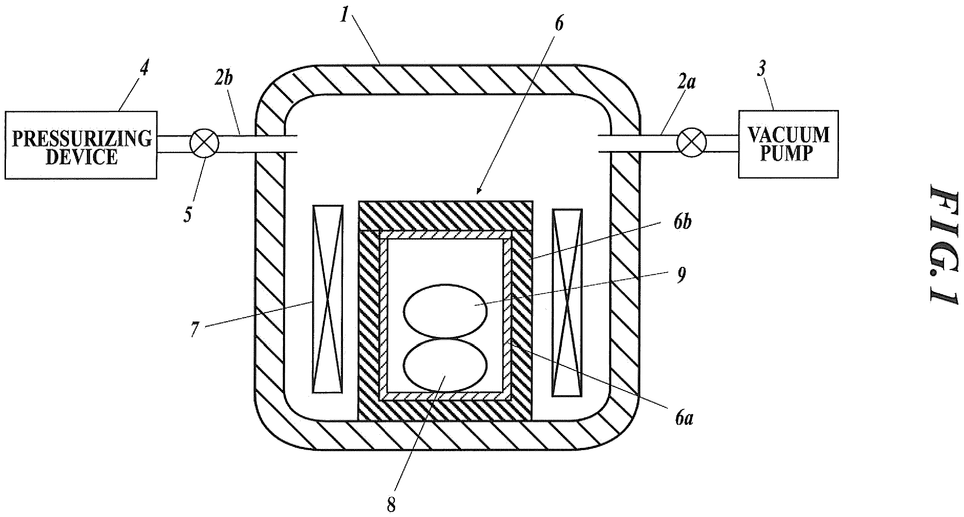

FIG. 1 is a schematic structure of a device for synthesizing a group II-VI compound semiconductor polycrystal, such as a CdTe polycrystal, according to an embodiment of the present invention. In FIG. 1, a high-pressure furnace, designated by symbol 1, is provided with a vacuum pump 3 connected by piping 2a and a pressurizing device 4 connected by piping 2b. The crystal synthesizing device is structured such that the high-pressure furnace 1 is evacuated by the vacuum pump 3 and the inner air is replaced with an inert gas such as a nitrogen gas (N2) through the piping 2b, and that an inert gas is filled with pressure by the pressurizing device 4 so as to control a pressure in the high-pressure furnace 1.

The pressurizing device 4 may include, for example, a high pressure gas-container. The pressure in the high-pressure furnace 1 may be set at a desirable pressure by introducing the gas into the furnace 1 from the high pressure gas-container via a pressure reducing valve and a pressure controller 5.

According to the crystal synthesizing device of an embodiment, a synthesis vessel 6 is placed around the center of the high-pressure furnace 1 and the vessel 6 is surrounded by a heater 7. The synthesis vessel 6 has a double-container structure of an inner vessel 6a and an outer vessel 6b. The inner vessel 6a is composed of a cylindrical crucible having an opening at an uppermost portion and a disc-shaped lid having a diameter almost the same as an outer diameter at the uppermost opening portion of the crucible, both of which are made of pBN.

The outer vessel 6b is composed of a cylindrical body having a diameter slightly larger than that of the inner vessel 6a and an opening at an uppermost portion and a disc-shaped lid having a diameter of almost the same as an outer diameter at the uppermost opening portion of the cylindrical body, both of which are made of graphite. Because the outer vessel 6b made of graphite is gas-permeable, it is preferable to coat its surface by glass fiber type coating agent. It contributes to reduced gas leakage from the outer vessel 6b.

In addition, it is structured such that the lid of the outer vessel 6b can be fixed on the cylindrical body in semi-airtight state by a screw that is not shown in the drawing. Preferably a height of an inner space of the outer vessel 6b is designed to be the same height as the total height of the inner vessel 6a. By virtue of the design, it becomes possible to prevent the lid of the inner vessel 6a from moving caused by an inner gas pressure because the lid of the outer vessel 6b holds down the lid of the inner vessel 6a from upper side when the lid of the outer vessel 6b is fixed on the cylindrical body. It is also preferable to provide a lid opening/closing mechanism to open and close the lids so as to perform gas exchange of the synthesis vessel at the same time of the gas exchange of the high-pressure furnace before synthesis.

For preparing a CdTe polycrystal, for example, with the crystal synthesizing device of FIG. 1, a predetermined weight of Cd block 8 and a predetermined weight of Te block 9 are put in the pBN crucible 6a as the inner vessel and lidded. The crucible is then set in the outer vessel 6b made of graphite and a lid is put on the outer vessel and fixed to the cylindrical body by screws. Next, the outer vessel is set in the high-pressure furnace 1, the furnace 1 is evacuated by the vacuum pump 3 and an inert gas is introduced in the furnace by the pressurizing device 4 so as to make inner pressure at 0.5 MPa or more. The inert gas introduced in the high-pressure furnace can prevent leakage of gasified raw materials from the synthesis vessel during temperature rising step.

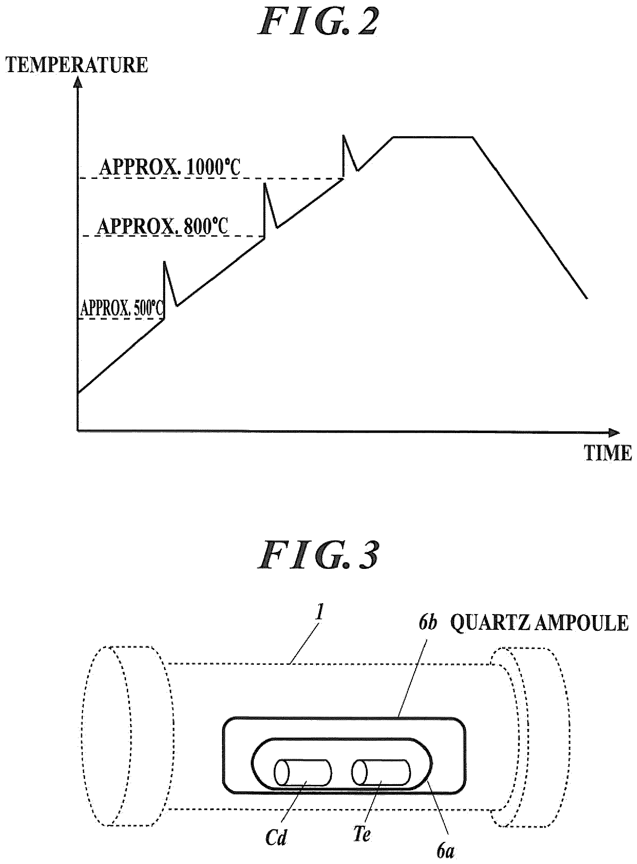

After that the inside of the high-pressure furnace 1 is heated by supplying electric power to the heater 7. FIG. 2 shows a temperature change in the furnace during the heating step. As can be seen by FIG. 2, at first the temperature in the furnace jumps temporarily around 500 degrees C, at which temperature the Cd and Te start to melt, by reaction heat caused by a first reaction. Next, the temperature in the furnace jumps temporarily around 800 to 900 degrees C because a second reaction occurs by non-reacted (remained) Cd and Te. If non-reacted Cd and Te is still remained, a third reaction will occur around 1000 degrees C.

The high-pressure furnace 1 is finally heated up to 1092 degrees C, as a melting point of CdTe, and remained in this state in predetermined period of time so as to react the Cd and Te completely to form CdTe. After that the inside of the furnace is cooled to promote growth of a CdTe polycrystal. The synthesis vessel 6 is then taken out, the lids of the inner vessel 6a and outer vessel 6b are removed and the CdTe polycrystal is taken out. According to the present invention, it is not necessary to break both of the inner vessel 6a and the outer vessel 6b and both of them can be reused.

### (Example)

A CdTe polycrystal was synthesized using the crystal synthesizing device explained in an exemplary embodiment having a pBN crucible of 6 inches in diameter and 40 cm in height. A Cd block and a Te block as raw materials, 20 kg in total weight, were put in the pBN crucible, the high-pressure furnace 1 was vacuumed and filled with an inert gas at a predetermined pressure (0.5 MPa, for example), the temperature was raised up to 1092 degrees C over a period of 1 hour, kept the state in two hours and cooled inside of the furnace to the room temperature over five hours to grow the CdTe polycrystal, according to the method above explained. The synthesizing experiments were repeated in 120 times. Both of the inner vessel 6a and the outer vessel 6b did not break at all during the 120 times experiments.

### (Comparative example 1)

As shown in FIG. 3, a Cd block and a Te block, 5 kg in total weight, were put in a pBN inner vessel 6a of 3 inches in diameter and 50 cm in length, the inner vessel 6a was put in a quartz outer vessel (quartz ampoule) 6b and vacuum sealed, and set in a high-pressure furnace 1 of a crystal synthesizing device which is similar to the device shown in FIG. 1. CdTe polycrystal synthesizing experiments were repeated by 120 times by the same sequence as explained above. That is, the high-pressure furnace 1 was heated up to 1092 degrees C over a period of 11 hours, kept the state in two hours and cooled to the room temperature over a period of 35 hours. An incident that the outer quartz ampoule burst occurred two times at the first to third reactions in 120 times experiments.

### (Comparative example 2)

A Cd block and a Te block, 20 kg in total weight, were put in a pBN inner vessel 6a of 6 inches in diameter and 40 cm in length as shown in FIG. 3, the inner vessel 6a was put in a quartz outer vessel (quartz ampoule) 6b and vacuum sealed, and set in a high-pressure furnace 1 of a crystal synthesizing device which is similar to the device shown in FIG. 1. CdTe polycrystal synthesizing experiments were repeated by 120 times by the same sequence as explained above. That is, the high-pressure furnace 1 was heated up to 1092 degrees C over a period of 11 hours, kept the state in two hours and cooled to the room temperature over a period of 35 hours. There occurred an incident that the outer quartz ampoule burst at the first to third reactions with a frequency of once every ten experiments.

It can be seen by the comparative examples 1 and 2 that, when a conventional synthesis method in which a quartz ampoule was used as an outer vessel 6b was applied, the quartz ampoule may sometimes burst and a frequency of the incident becomes high as the size of the ampoule becomes large. Thus the limitation of synthesis weight by the conventional method using the quartz ampoule was about 10 kg at a once.

According to an exemplary embodiment and comparative examples 1 and 2, it can be understood that the CdTe polycrystal can be grown by utilizing a graphite vessel instead of a quartz ampoule as an outer vessel 6b. In addition, an incident that the graphite vessel burst did not occur during the synthesis and thus the graphite vessel can be reused. Further, the pBN inner vessel 6a having a diameter of 20 cm or larger can be used and thus a polycrystal can be synthesized at least 20 kg or more at a time of synthesis, which resulting in an increasing of synthesis efficiency. Although an initial manufacturing cost of the graphite vessel is higher than that of the quartz ampoule, the total costs for synthesizing polycrystals can be reduced because several tens times of repeated usage are possible and single-use waste, which is generated when using a quartz ampoule, is eliminated.

An exemplary embodiment of the present invention was explained in details by way of an example and thus it is not restrictive. For example, the inner pressure of the high-pressure furnace 1 before heating was set 0.5 MPa in an embodiment. However, the inner pressure is not limited to 0.5 MPa but may be preferably 0.5 MPa to 1 MPa.

Temperature raising rate is not limited to an embodiment, either. It may be 100 to 2000 degrees C per hour. It was explained that the high-pressure furnace 1 was filled with an inert gas at a predetermined pressure in an embodiment. However, it can be structured such that a reservoir portion is provided in the high-pressure furnace 1 so as to produce vapor of one of the raw materials (Cd, for example).

The present invention is applied to synthesize the CdTe polycrystal in the above explanation. However, the present invention can be applied to synthesize group II-VI compound semiconductor polycrystals other than CdTe polycrystal.

### Explanation of Symbols

1 high-pressure furnace
2a, 2b piping
3 vacuum pump
4 pressurizing device
5 pressure controller
6 synthesis vessel (inner vessel 6a, outer vessel 6b)
7 heater
8 Cd block
9 Te block

## Claims

1. A method for synthesizing a group II-VI compound semiconductor polycrystal, comprising:
preparing:
a pBN inner vessel composed of a cylindrical crucible having an opening at an uppermost portion and a disc-shaped lid having a diameter almost the same as an outer diameter at the uppermost opening portion of the crucible; and
a heat-resistant outer vessel composed of a cylindrical body having an opening at an uppermost portion and a disc-shaped lid having a profile substantially the same as a profile of the uppermost portion of the outer body, the outer vessel having an inner space with a same height as a total height of the inner vessel, wherein the outer vessel is structured such that the lid of the outer vessel can be fixed on the cylindrical body in a semi-airtight state by a screw,
putting two or more raw material elements of group II and group VI in the inner body of the inner vessel and putting the inner lid on the uppermost portion of the inner body,
putting the inner vessel in the outer body of the outer vessel and fixing the outer lid on the upper most portion of the outer body,
placing the outer vessel in a high-pressure furnace having a heating means,
evacuating the high-pressure furnace and filling the high-pressure furnace with an inert gas at a predetermined pressure,
heating the inner vessel and the outer vessel by the heating means so as to melt and promote a reaction of the raw material elements in the inner vessel, and
cooling the reacted raw material elements so as to promote a growth of a polycrystal,
wherein the inert gas pressure in the high-pressure furnace before heating is 0.5 MPa to 1 MPa,
wherein the outer vessel is made of graphite and a surface of the outer vessel is covered with a coating layer.

2. The method of claim 1, wherein the coating layer is a glass fiber.

3. The method of claim 1, wherein the element of group II is Cd and the element of group VI is Te.

4. The method of claim 1, wherein the group II-VI compound semiconductor polycrystal is a CdTe polycrystal, and a temperature raising rate at the heating step is 100 to 2000 degrees C per hour.

5. The method of claims 3 or 4 wherein the final temperature of the high pressure furnace is 1092 degrees C.

## Patentansprüche

1. Verfahren zum Synthetisieren eines Gruppe 11-VI-Verbundhalbleiter-Polykristalls, das Folgendes umfasst:
Zubereiten:
eines inneren pBN-Gefäßes, das aus einem zylindrischen Schmelztiegel mit einer Öffnung an einem obersten Abschnitt und einem scheibenförmigen Deckel mit einem Durchmesser, der beinahe gleich einem Außendurchmesser an dem obersten Öffnungsabschnitt des Schmelztiegels ist, gebildet ist; und
ein hitzebeständiges äußeres Gefäß, das aus einem zylindrischen Körper mit einer Öffnung an einem obersten Abschnitt und einem scheibenförmigen Deckel mit einem Profil, das im Wesentlichen gleich einem Profil des obersten Abschnitts des äußeren Körpers ist, gebildet ist, wobei das äußere Gefäß einen inneren Raum mit einer gleichen Höhe wie eine Gesamthöhe des inneren Gefäßes aufweist, wobei das äußere Gefäß derart aufgebaut ist, dass der Deckel des äußeren Gefäßes mittels einer Schraube in einem halbluftdichten Zustand auf dem zylindrischen Körper fixiert werden kann,
Platzieren von zwei oder mehr Ausgangsstoffelementen der Gruppe II und der Gruppe VI in den inneren Körper des inneren Gefäßes und Platzieren des inneren Deckels auf den obersten Abschnitt des inneren Körpers,
Platzieren des inneren Gefäßes in den äußeren Körper des äußeren Gefäßes und Fixieren des äußeren Deckels auf dem obersten Abschnitt des äußeren Körpers,
Stellen des äußeren Gefäßes in einen ein Heizmittel aufweisenden Hochdruckofen,
Evakuieren des Hochdruckofens und Füllen des Hochdruckofens mit einem Inertgas unter einem vorbestimmten Druck,
Erhitzen des inneren Gefäßes und des äußeren Gefäßes mittels des Heizmittels, um die Ausgangsstoffelemente in dem inneren Gefäß zu schmelzen und eine Reaktion derselben zu fördern, und
Abkühlen der reagierten Ausgangsstoffelemente, um ein Wachstum eines Polykristalls zu fördern,
wobei der Inertgasdruck in dem Hochdruckofen vor dem Erhitzen 0,5 MPa bis 1 MPa beträgt,
wobei das äußere Gefäß aus Graphit hergestellt ist und eine Oberfläche des äußeren Gefäßes mit einer Beschichtungsschicht beschichtet ist.

2. Verfahren nach Anspruch 1, wobei es sich bei der Beschichtungsschicht um eine Glasfaser handelt.

3. Verfahren nach Anspruch 1, wobei es sich bei dem Element der Gruppe II um Cd handelt und es sich bei dem Element der Gruppe VI um Te handelt.

4. Verfahren nach Anspruch 1, wobei es sich bei dem Gruppe II-VI-Verbundhalbleiter-Polykristall um einen CdTe-Polykristall handelt und eine Temperaturerhöhungsgeschwindigkeit in dem Heizschritt 100 bis 2000 Grad C pro Stunde beträgt.

5. Verfahren nach Anspruch 3 oder 4, wobei die Endtemperatur des Hochdruckofens 1092 Grad C beträgt.

## Revendications

1. Procédé de synthétisation d'un polycristal semiconducteur composite du groupe II-VI, comprenant :
la préparation :
d'un récipient intérieur en nitrure de bore pyrolityque composé d'un creuset cylindrique ayant une ouverture au niveau d'une partie supérieure et un couvercle en forme de disque ayant un diamètre presque le même qu'un diamètre extérieur au niveau de la partie supérieure à ouverture du creuset ; et
un récipient extérieur résistant à la chaleur composé d'un corps cylindrique ayant une ouverture au niveau d'une partie supérieure et un couvercle en forme de disque ayant un profil essentiellement le même qu'un profil de la partie supérieure du corps extérieur, ce récipient extérieur ayant un espace intérieur avec une même hauteur qu'une hauteur totale du récipient intérieur, ce récipient extérieur étant structuré de manière à ce que le couvercle du récipient extérieur puisse être fixé sur le corps cylindrique dans un état à moitié étanche à l'air par une vis,
la mise de deux éléments de matière brute ou plus du groupe II et du groupe VI dans le corps intérieur du récipient intérieur et la mise du couvercle intérieur sur la partie supérieure du corps intérieur,
la mise du récipient intérieur dans le corps extérieur du récipient extérieur et la fixation du couvercle extérieur sur la partie supérieure du corps extérieur,
la mise en place du récipient extérieur dans un four à haute pression ayant un moyen de chauffage,
l'évacuation du four à haute pression et le remplissage du four à haute pression avec un gaz inerte à une pression prédéterminée,
le chauffage du récipient intérieur et du récipient extérieur par le moyen de chauffage de manière à fondre les éléments de matière brute dans le récipient intérieur et à favoriser une réaction de ceux-ci, et
le refroidissement des éléments de matière brute ayant réagi de manière à favoriser une croissance d'un polycristal,
la pression du gaz inerte dans le four à haute pression avant le chauffage étant de 0,5 MPa à 1 MPa,
le récipient extérieur étant fait de graphite et une surface du récipient extérieur étant couverte avec une couche de revêtement.

2. Procédé selon la revendication 1, dans lequel la couche de revêtement est une fibre de verre.

3. Procédé selon la revendication 1, dans lequel l'élément du groupe II est du cadmium et l'élément du groupe VI est du tellure.

4. Procédé selon la revendication 1, dans lequel le polycristal semi-conducteur composite du groupe II-VI est un polycristal CdTe, et une vitesse d'augmentation de la température lors de l'étape de chauffage est de 100 à 2000 degrés C par heure.

5. Procédé selon la revendication 3 ou 4, dans lequel la température finale du four à haute pression est 1092 degrés C.
